# EUROPEAN PATENT APPLICATION

(11) **EP 3 998 648 A1**
(43) Date of publication of application: **18.05.2022**
(21) Application number: 20836678.1
(22) Date of filing: 13.07.2020
(51) Int. Cl.: H01L 51/00, H01L 51/50

(54) **ORGANIC-INORGANIC HYBRID LAYER, ORGANIC-INORGANIC LAMINATE COMPRISING SAME LAYER, AND ORGANIC ELECTRONIC ELEMENT COMPRISING SAME LAMINATE AS GAS BARRIER**

(30) Priority: 11.07.2019 KR 20190083749
(71) Applicant: Industry-University Cooperation Foundation Hanyang University, Seoul 04763 (KR)
(72) Inventor: SUNG, Myung Mo, Seoul 06636 (KR); PARK, Jin Seon, Seoul 07642 (KR)
(74) Representative: dompatent von Kreisler Selting Werner - Partnerschaft von Patent- und Rechtsanwälten mbB
(86) International application number: PCT/KR2020/009169
(87) International publication number: WO 2021/006712

(57) **Abstract**

An organic-inorganic hybrid layer, an organic-inorganic laminate having the same, and an organic electronic device having the same as a gas barrier are provided. The organic-inorganic laminate may include at least two metal oxide layers; and an organic-inorganic hybrid layer disposed between the metal oxide layers and including at least one unit layer including a metal atomic layer and an organic molecular layer represented by Formula 1 or 2 below:

[Formula 1] (-XₐRₐ) (X_{b1}R_{b}) C (R_{c}X_{c}-) (R_{d}X_{d}-)

[Formula 2] (-XₐRₐ) (-X_{b2}R_{b}) C (R_{c}X_{c}-) (R_{d}X_{d}-)

In Formula 1 or Formula 2, a plurality of - means a bond with a metal in the metal atomic layer or the metal oxide layer regardless of each other, and Xₐ, X_{b2}, X_{c}, and X_{d} are O, S, Se or NH regardless of each other, X_{b1} is hydrogen, and Rₐ, R_{b}, R_{c}, and R_{d} are, irrespective of each other, a bond or a C1 to C5 alkylene group.

## Description

### [Technical Field]

The present invention relates to an organic-inorganic laminate, and more particularly, to a laminate in which an organic layer and an inorganic layer are alternately laminated.

### [Background Art]

Glass substrates used in display devices, picture frames, crafts, containers, etc. have several advantages such as a small coefficient of linear expansion, excellent gas barrier properties, high light transmittance, surface flatness, excellent heat and chemical resistance, etc. However, it has a disadvantage that it is easily broken by impact and is heavy because of its high density.

Recently, as interest in liquid crystal displays, organic light emitting displays, and electronic papers has rapidly increased, research on replacing the substrates of these display devices with plastics from glass is being actively conducted. That is, when a glass substrate is replaced with a plastic substrate, the overall weight of the display device can be reduced, design flexibility can be given, and it is strong in impact and economical compared to a glass substrate when manufactured by a continuous process.

In order to actively utilize the properties of the plastic substrate, methods for performing various treatments on the plastic substrate are being studied. For example, Korea Patent Registration Publication (10-1296623) discloses that a low-cost plastic substrate can be planarized and uniformed by coating an organic film on plastic such as polyethylene naphthalate and heat-treating it to cure the organic film, and discloses a method of improving stability of a manufacturing process of a display device by preventing deterioration of respective wirings of a display device due to process heat generated during the process.

### [Disclosure]

### [Technical Problem]

Accordingly, an object of the present invention is to provide an organic-inorganic hybrid layer having excellent reliability, an organic-inorganic laminate having the same, and a gas barrier so as to improve stability of a display device and the like.

The technical problems of the present invention are not limited to the technical problems mentioned above, and other technical problems not mentioned will be clearly understood by those skilled in the art from the following description.

### [Technical Solution]

In order to achieve the above technical problem, one aspect of the present invention provides an organic-inorganic laminate. The organic-inorganic laminate may include at least two metal oxide layers; and an organic-inorganic hybrid layer disposed between the metal oxide layers and including at least one unit layer including a metal atomic layer and an organic molecular layer represented by Formula 1 or 2 below:

[Formula 1] (-XₐRₐ) (X_{b1}R_{b}) C (R_{c}X_{c}-) (R_{d}X_{d}-)

[Formula 2] (-XₐRₐ) (-X_{b2}R_{b}) C (R_{c}X_{c}-) (R_{d}X_{d}-)

In Formula 1 or Formula 2, a plurality of - means a bond with a metal in the metal atomic layer or the metal oxide layer regardless of each other, and Xₐ, X_{b2}, X_{c}, and X_{d} are O, S, Se or NH regardless of each other, X_{b1} is hydrogen, and Rₐ, R_{b}, R_{c}, and R_{d} are, irrespective of each other, a bond or a C1 to C5 alkylene group.

The C1 to C5 alkylene group may be a C1 to C3 alkylene group. Xₐ may be O, X_{b2} may be O, X_{c} and X_{d} may be S, and X_{b1} may be hydrogen. The organic molecular layer may be (-OCH₂)HC(S-)(CH₂S-). The metal oxide layer may be a transition metal oxide, a post-transition metal oxide, or a metalloid oxide layer. The metal oxide layer may be an Al₂O₃ layer. The metal oxide layer may be a layer in which metal atomic layers and oxygen atomic layers are alternately stacked. The metal atomic layer of the organic-inorganic hybrid layer may be an Al layer.

In order to achieve the above technical problem, one aspect of the present invention provides an organic-inorganic laminate. The organic-inorganic laminate may include alternately stacked first metal oxide layers and organic-inorganic hybrid layers. A second metal oxide layer is disposed on an uppermost organic-inorganic hybrid layer among the alternately stacked first metal oxide layers and organic-inorganic hybrid layers. The organic-inorganic hybrid layer includes at least one unit layer including a metal atom layer and an organic molecular layer. The organic molecular layer has an alkyl group having 2 to 21 carbon atoms as a body, oxygen(s) bonded to the metal atom layer at one or two of the four vertices of the tetrahedron centered on any one carbon atom of the alkyl group, and sulfurs bonded to the metal of the metal oxide layer at two of the four vertices of the tetrahedron.

The organic molecular layer may be represented by Formula 1 or Formula 2 below.

[Formula 1] (-XₐRₐ) (X_{b1}R_{b}) C (R_{c}X_{c}-) (R_{d}X_{d}-)

[Formula 2] (-XₐRₐ) (-X_{b2}R_{b}) C (R_{c}X_{c}-) (R_{d}X_{d}-)

In Formula 1 or Formula 2, -Xₐ and - X_{b2} are oxygen bonded to the metal atomic layer, -X_{c} and -X_{d} are sulfur bonded to the metal of the metal oxide layer, X_{b1} is hydrogen, Rₐ, R_{b}, R_{c}, and R_{d} are a bond or a C1 to C3 alkylene group regardless of each other, but the total number of carbons constituting Rₐ, R_{b}, R_{c}, and R_{d} may be 1 to 9.

The organic molecular layer may be (-OCH₂)HC(S-)(CH₂S-). The metal oxide layer may be an Al₂O₃ layer in which Al atomic layers and oxygen atomic layers are alternately stacked. The metal atomic layer of the organic-inorganic hybrid layer may be an Al layer.

In order to achieve the above technical problem, an aspect of the present invention provides an organic-inorganic hybrid layer. The organic-inorganic hybrid layer includes at least one unit layer including a metal atomic layer and an organic molecular layer represented by Formula 1 or 2 below.

[Formula 1] (-XₐRₐ) (X_{b1}R_{b}) C (R_{c}X_{c}-) (R_{d}X_{d}-)

[Formula 2] (-XₐRₐ) (-X_{b2}R_{b}) C (R_{c}X_{c}-) (R_{d}X_{d}-)

In Formula 1 or Formula 2, a plurality of - means a bond, and Xₐ, X_{b2}, X_{c}, and X_{d} are O, S, Se or NH regardless of each other, X_{b1} is hydrogen, and Rₐ, R_{b}, R_{c}, and R_{d} are, irrespective of each other, a bond or a C1 to C5 alkylene group. In Formula 1 or Formula 2, Xₐ and X_{b2} may be oxygen, X_{c} and X_{d} may be sulfur, X_{b1} may be hydrogen, and Rₐ, R_{b}, R_{c}, and R_{d} may be a bond or a C1 to C3 alkylene group regardless of each other, but the total number of carbons constituting Rₐ, R_{b}, R_{c}, and R_{d} may be 1 to 9.

The organic molecular layer may be (-OCH₂)HC(S-)(CH₂S-). The metal atomic layer may be an Al layer.

In order to achieve the above technical problem, an aspect of the present invention provides an organic electronic device. The organic electronic device includes the organic-inorganic laminate as a gas barrier layer.

### [Advantageous Effects]

As described above, according to the present invention, the organic-inorganic laminate or organic-inorganic hybrid layer has a linear or branched alkyl group having 2 to 21 carbon atoms as a body forming a tetrahedron centered on any one carbon atom of the alkyl group, an element (s) binding to metal at one or two of four vertices of the tetrahedron, and elements binding to metal at the other two of four vertices of the tetrahedron to exhibit excellent gas barrier properties even when subjected to stress such as bending.

However, the effects of the present invention are not limited to the above-mentioned effects, and other effects not mentioned will be clearly understood by those skilled in the art from the following description.

### [Description of Drawings]

FIG. 1 is a schematic view showing an organic-inorganic laminate including an organic-inorganic hybrid layer according to an embodiment of the present invention.
FIG. 3 is a cross-sectional view showing an organic electronic device having an organic-inorganic laminate according to an embodiment of the present invention.
FIG. 4 is a schematic diagram illustrating a process according to the organic-inorganic hybrid film Preparation Example 1.
FIG. 5a is a graph showing the thickness of the organic-inorganic hybrid film per unit cycle as a result of changing the TMA dosing time in the TMA dosing step in the process of the organic-inorganic hybrid film Preparation Example 1, Figure 5b is a graph showing the thickness of the organic-inorganic hybrid film per unit cycle according to the change of the DMP dosing time in the DMP dosing step in the process of the organic-inorganic hybrid film Preparation Example 1.
FIG. 6 is a graph showing the thickness of the organic-inorganic hybrid film according to the number of unit cycles according to the organic-inorganic hybrid film Preparation Example 1.
FIG. 7 is an image obtained by measuring the surface of the resultant product after performing the unit cycle according to the organic-inorganic hybrid film Preparation Example 1 15 times using an atomic force microscope (AFM).
FIG. 8 shows the results according to the air stability test 1.
FIG. 9 shows the results according to the air stability test 2.

### [Modes of the Invention]

Hereinafter, preferred embodiments according to the present invention will be described in more detail with reference to the accompanying drawings in order to explain the present invention in more detail. However, the present invention is not limited to the embodiments described herein and may be embodied in other forms. In the drawings, when it is said that a layer is "on" another layer or substrate, it may be formed directly on the other layer or substrate, or a third layer may be interposed therebetween. In the present embodiments, "first", "second", or "third" is not intended to impose any limitation on the components, but should be understood as terms for distinguishing the components.

In the present specification, unless otherwise defined, "alkyl" refers to an aliphatic hydrocarbon group, and may be "saturated alkyl" that does not include any double bond or any triple bond. The saturated alkyl group may be linear. As an example, alkyl may be a methyl, ethyl, or propyl group.

In the present specification, unless otherwise defined, "alkylene" refers to a divalent group that is a radical of alkane, which is a saturated hydrocarbon, and may be linear alkylene.

In the present specification, when it is described as "carbon number X to carbon number Y", it should be construed as described as having a number of carbon atoms corresponding to all integers between carbon number X and carbon number Y.

When it is described as "X to Y" in the present specification, it should be construed that the numbers corresponding to all integers between X and Y are also described.

In the present specification, "atomic layer" is an atomic layer defined in the atomic layer deposition method, and may be a monoatomic layer that is one atomic layer, and "molecular layer" is a molecular layer defined in the molecular layer deposition method, which may be a single molecular layer.

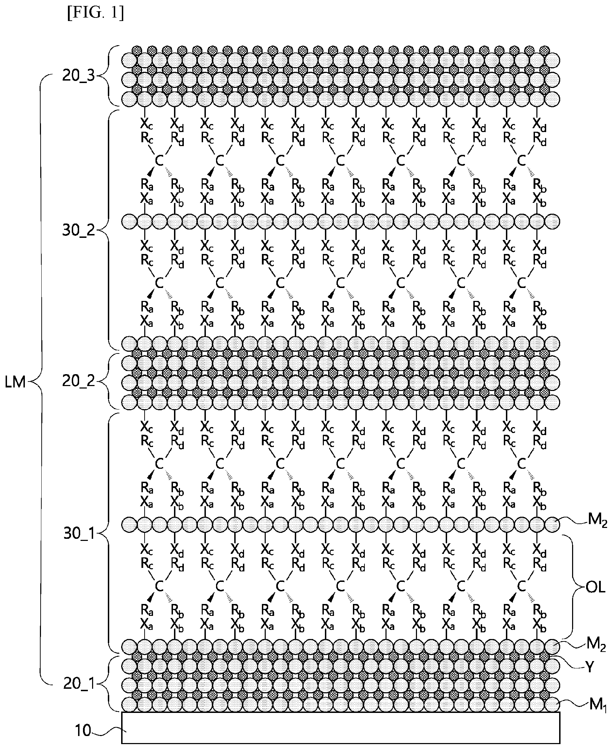

FIG. 1 is a schematic view showing an organic-inorganic laminate including an organic-inorganic hybrid layer according to an embodiment of the present invention.

Referring to FIG. 1, a substrate 10 may be provided. The substrate may be a bare substrate that is a semiconductor substrate, a glass substrate, or a flexible substrate. For example, the flexible substrate may be a polymer substrate. At least one device (not shown) such as a transistor, a memory, a diode, a solar cell, an optical device, a biosensor, a nanoelectromechanical system (NEMS), a microelectromechanical system (MEMS), a nanodevice, or a chemical sensor may be formed on the substrate. The device may be an organic electronic device such as an organic light emitting diode or an organic solar cell. In addition, a protective layer (not shown) such as an insulating film covering the device may be formed on the device. In the present embodiment, the substrate 10 may be the bare substrate, or a substrate in which the device is formed on the bare substrate or in which the device and the protective layer are formed on the bare substrate.

The substrate 10 may have a hydroxyl group on its surface or may be surface-treated to have a hydroxyl group. When the substrate 10 is a semiconductor substrate, a hydroxyl group may be provided due to the generation of a natural oxide film, and if the substrate 10 is a glass substrate or an insulating film such as a silicon oxide film, the substrate 10 may have a hydroxyl group. When the upper surface of the substrate 10 is a polymer layer, a hydroxyl group may be generated on the upper surface by surface treatment using ultraviolet rays. However, the present invention is not limited thereto.

An organic-inorganic laminate LM may be formed on the substrate 10. The organic-inorganic laminate LM is a layer in which metal oxide layers 20_1, 20_2, and 20_3 and organic-inorganic hybrid layers 30_1 and 30_2 are alternately stacked. Specifically, a pair of the metal oxide layer and the organic-inorganic hybrid layer may be repeatedly laminated 1 to 200 times, specifically, 10 to 150 times, or 20 to 100 times, and then the metal oxide layer 20_3 may be laminated on the uppermost layer. In other words, the organic-inorganic laminate LM may have a structure in which at least one organic-inorganic hybrid layer between the two metal oxide layers 20_1, 20_2, and 20_3 or between the two or more metal oxide layers 20_1, 20_2, 20_3.

The metal oxide layer 20_1, 20 2, or 20_3 may be a transition metal oxide, a post-transition metal oxide, or a metalloid oxide layer. Specifically, the metal oxide layer 20_1, 20_2, or 20_3 may be an oxide layer of at least one selected from zinc (Zn), tin (Sn), indium (In), cadmium (Cd), aluminum (Al), titanium (Ti), manganese (Mn), iron (Fe), cobalt (Co), copper (Cu), tungsten (W), and silicon (Si). Each of the metal oxide layers 20_1, 20_2, and 20_3 may be oxide layers of different metals or oxide layers of the same metal. As an example, the metal oxide layers 20_1, 20_2, and 20_3 may be aluminum oxide layers, specifically, an Al₂O₃ layers.

The metal oxide layer 20_1, 20_2, or 20_3 may be a layer in which a first metal atomic layer M1 and an oxygen atomic layer Y are alternately stacked. To this end, the metal oxide layers 20_1, 20_2, and 20_3 may be formed using an atomic layer deposition (ALD) method. Specifically, the metal oxide layers 20_1, 20_2, and 20_3 may be formed by repeating a unit cycle several times after the substrate 10 is loaded into a reaction chamber, wherein the unit cycle may include a metal precursor dosing step of chemically bonding the surface of the substrate 10, the oxygen atomic layer (Y), or the surface of the organic-inorganic hybrid layer (30_1, 30_2) with a metal precursor by dosing the metal precursor into the reaction chamber; a purge step of purging an unreacted metal precursor and a reaction product by supplying a purge gas; an oxidizing agent dosing step of dosing an oxidizing agent to oxidize the chemically bonded metal precursor; and a purge step of purging the unreacted oxidizing agent and the reaction product by supplying a purge gas. The metal precursor may be an alkyl metal, a metal alkoxide, a metal halide, a metal hydroxide, or mixtures thereof.

As an example, when the metal oxide layers 20_1, 20_2, and 20_3 are Al₂O₃ layers, the metal precursor may be alkyl aluminum, specifically, trimethyl aluminum (TMA; Al(CH₃)₃), and the oxidizing agent may be H₂O. However, the present invention is not limited thereto.

When the unit cycle is performed once, about one first metal atomic layer M1 and about one oxygen atomic layer Y may be formed thereon. As an example, the formation of each of the metal oxide layers 20_1, 20_2, and 20_3 may be performed by repeating the unit cycle 3 to 100 times, specifically 5 to 50 times, for example, 8 to 25 times. In addition, when the metal oxide layer is an Al₂O₃ layer in which Al atomic layers and oxygen atomic layers are alternately stacked, the growth thickness per unit cycle may be about 0.8 to 1.2 Å.

However, the present invention is not limited thereto, and the metal oxide layers 20_1, 20_2, and 20_3 may be formed by various methods such as chemical vapor deposition (CVD), physical vapor deposition (PVD), and E beam evaporation.

Each of the metal oxide layers 20_1, 20_2, and 20_3 may be formed to a thickness of about 3 to 100 Å, specifically, about 5 to 50 Å, for example, about 8 to 25 Å.

Each of the organic-inorganic hybrid layers 30_1 and 30_2 may be a layer including at least one unit layer, for example, 1 to 5 unit layers, wherein the unit layer may include the second metal atomic layer M2 and the organic molecular layer OL. FIG. 1 illustrates an example in which the unit layer including the second metal atomic layer M2 and an organic molecular layer OL is stacked twice.

At this time, the second metal atomic layer M2 may be a layer including zinc (Zn), tin (Sn), indium (In), cadmium (Cd), aluminum (Al), titanium (Ti), manganese (Mn), iron (Fe), cobalt (Co), copper (Cu), tungsten (W), or silicon (Si), and may be the same as the first metal atomic layer M1 in the metal oxide layers 20_1, 20_2, and 20_3 or may be different. As an example, the second metal atomic layer M2 may be an aluminum (Al) atomic layer.

The organic molecular layer OL may be represented by Formula 1 or 2 below:

[Formula 1] (-XₐRₐ) (X_{b1}R_{b}) C (R_{c}X_{c}-) (R_{d}X_{d}-)

[Formula 2] (-XₐRₐ) (-X_{b2}R_{b}) C (R_{c}X_{c}-) (R_{d}X_{d}-)

In Formula 1 or Formula 2, - may denote a bond with an element in the upper or lower layer of the organic molecular layer, for example, a covalent bond, and as an example, a bond with a metal (an adjacent metal among M1 or M2). Some of them may denote a bond with the metal in the lower layer and others may denote bonds with the metal in the upper layer. Xₐ, X_{b2}, X_{c}, and X_{d} may be O, S, Se or NH regardless of each other, and X_{b1} may be hydrogen. In addition, Rₐ, R_{b}, R_{c}, and R_{d} may be a bond or a C1 to C5 alkylene group regardless of each other. The C1 to C5 alkylene group may be a C1 to C3 alkylene group. In one example, the C1 to C5 alkylene group may be a C1 to C2 alkylene group. The alkylene groups may be linear alkylene groups. In one example, the total number of carbons constituting Rₐ, R_{b}, R_{c}, and R_{d} may be 1 to 20, specifically 2 to 15, for example, 2 to 9.

In FIG. 1, X_{b} may be X_{b1} or X_{b2}, and when X_{b} is X_{b1}, it may be in a state not bound to a metal, and when X_{b} is X_{b2}, it may be in a state bound to a metal.

In one example, one or two of Xₐ, X_{b2}, X_{c}, and X_{d} may be a functional group that is more reactive towards a metal than the others, and the more reactive functional group(s) binds to a metal in the underlying metal layer, the remainder may bond with the metal in the metal layer overlying. In one embodiment, Xₐ (and X_{b2}) may be a functional group that is more reactive towards metal than X_{c} and X_{d}, Xₐ (and X_{b2}) may bind to a metal in the underlying metal layer, and X_{c} and X_{d} may bind to a metal in the overlying metal layer. As an example, Xₐ may be O, X_{b2} may be O, X_{c} and X_{d} may be S, and X_{b1} may be hydrogen. However, the present invention is not limited thereto, and Xₐ, X_{b2}, X_{c}, and X_{d} may be selected independently of each other from O, S, Se or NH as long as Xₐ and X_{b2} have high reactivity compared to X_{c} and X_{d}.

The organic molecular layer OL may be, for example, (-XₐCH₂)HC(X_{c}-)(CH₂X_{d}-), (-XₐCH₂)(-X_{c})CH(CH₂X_{d}-), (-XₐCH₂)(-X_{c}CH₂)CH(X_{d}-), (-Xₐ)HC(CH₂X_{c}-)(CH₂CH₂X_{d}-), (-XₐCH₂)HC(CH₂X_{c}-)(CH₂X_{d}-), (-XₐCH₂CH₂)HC(CH₂X_{c}-)(X_{d}-), or (-Xₐ)(-X_{b2})C(X_{c}-)(CH(CH₂CH₃)X_{d}-), more specifically (-OCH₂)HC(S-)(CH₂S-), (-OCH₂)(-O)CH(CH₂S-), (-OCH₂)(-OCH₂)CH(S-), (-O)HC(CH₂S-)(CH₂CH₂S-), (-OCH₂)HC(CH₂S-)(CH₂S-), (-OCH₂CH₂)HC(CH₂S-)(S-), or (-O)(-O)C(S-)(CH(CH₂CH₃)S-).

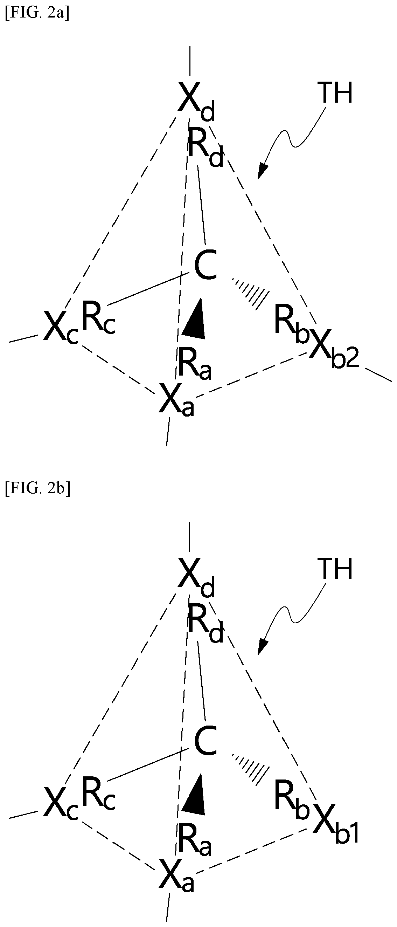

FIGs. 2a and 2b are schematic diagrams illustrating organic molecules in the organic molecular layer represented by Chemical Formula 1 or Chemical Formula 2, respectively.

Referring to FIGs. 2a and 2b, the organic molecules in the organic molecular layer OL represented by Formula 1 or Formula 2 may have a linear or branched alkyl group of (Rₐ)(R_{b})C(R_{c})(R_{d}) having 2 to 21 carbon atoms as a body, and the body has the shape of a tetrahedron (TH) centered on a carbon atom of the alkyl groups, and Xₐ, X_{b2} (or X_{b1}), X_{c}, and X_{d} are located at each vertex of the tetrahedron (TH), and at least three of them are functional groups capable of bonding to a metal, and thus can be formed with excellent coverage between metal atomic layers.

Furthermore, one or two of the functional groups of Xₐ, X_{b2}, X_{c}, and X_{d} have higher reactivity than other functional groups, and thus may better bind to the metal on the reaction surface, that is, the metal atomic layer M2. In other words, an imaginary edge of the tetrahedron TH connecting the more reactive functional groups (ex. Xₐ and X_{b2}) may be adjacent to the metal on the reaction surface, that is, the metal atomic layer M2, and other imaginary edge of the tetrahedron TH connecting the remaining functional groups (ex, X_{c} and X_{d}) may be disposed adjacent to the upper metal layer. Accordingly, organic molecules in the organic molecular layer OL may be very stably disposed between the atomic metal layers, and may also exhibit better coverage.

In addition, since the organic molecular layer (OL) represented by Formula 1 or Formula 2 has a linear or branched alkyl group of (Rₐ)(R_{b})C(R_{c})(R_{d}) having 2 to 21 carbon atoms as a body and has no π-π bonding, flexibility may be improved compared to the case where an aryl group is provided in the body. As a result, the organic molecular layer OL has a low risk of being damaged even under stress such as bending, so that reliability can be maintained.

Referring back to FIG. 1, each of the organic-inorganic hybrid layers 30_1 and 30_2 can be formed by using an atomic layer deposition method to form a metal atomic layer M2 and a molecular layer deposition method (MLD) to form an organic molecular layer OL.

Specifically, the step of forming the metal atomic layer M2 may comprises a dosing step of a metal precursor and a purge step. In the dosing step, the metal precursor may be dosed into the reaction chamber to chemically bond the metal precursor to the surface of the metal oxide layers 20_1 and 20_2 or the organic molecular layer OL. In the purge step, unreacted metal precursors and reaction products may be purged by supplying a purge gas into the reaction chamber. In addition, the forming of the organic molecular layer OL includes dosing an organic precursor to chemically bond the organic precursor to the metal atomic layer M2, and supplying a purge gas to purge unreacted organic precursors and reaction products. Each of the organic-inorganic hybrid layers 30_1 and 30_2 may be formed by repeating a unit cycle including the forming of the metal atomic layer M2 and the forming of the organic molecular layer OL 1 to 5 times.

The organic precursor for forming the organic molecular layer OL constituting the organic-inorganic hybrid layers 30_1 and 30_2 may be represented by Chemical Formula 3 or Chemical Formula 4 below.

[Chemical Formula 3] (HXₐRₐ)(X_{b1}R_{b})C(R_{c}X_{c}H)(R_{d}X_{d}H)

[Chemical Formula 4] (HXₐRₐ)(HX_{b2}R_{b})C(R_{c}X_{c}H)(R_{d}X_{d}H)

In Formula 3 or Formula 4, Xₐ, X_{b2}, X_{c}, X_{d}, X_{b1}, Rₐ, R_{b}, R_{c}, and R_{d} are as defined in Formula 1 or 2 above.

In one example, the organic precursor may be HXₐCH₂HC(X_{c}H)CH₂X_{d}H, HXₐCH₂(HX_{c})CHCH₂X_{d}H, HXₐCH₂(HX_{c}CH₂)CHX_{d}H, HXₐHC(CH₂X_{c}H)CH₂CH₂X_{d}H, HXₐCH₂HC(CH₂X_{c}H)CH₂X_{d}H, HXₐCH₂CH₂HC(CH₂X_{c}H)X_{d}H, or HXₐ(HX_{b2})C(X_{c}H)CH(CH₂CH₃)X_{d}H, more specifically HOCH₂HC(SH)CH₂SH (2,3-dimercapto-1-propanol), HOCH₂(HO)CHCH₂SH (3-Sulfanyl-1,2-propanediol), HOCH₂(HOCH₂)CHSH (2-Sulfanyl-1,3-propanediol), HOCH(CH₂SH)CH₂CH₂SH(1,4-disulfanyl-2-butanol), HOCH₂CH(CH₂SH)CH₂SH (3-sulfanyl-2-(sulfanylmethyl)-1-propanol), HOCH₂CH₂CH(CH₂SH)SH (3,4-Disulfanyl-1-butanol), or HO(HO)C(SH)CH(CH₂CH₃)SH (1,2-Disulfanyl-1,1-butanediol).

An example of the metal precursor dosing step for forming the organic-inorganic hybrid layers 30_1 and 30_2 may be represented by Scheme 1 below, and an example of the organic precursor dosing step may be represented by Scheme 2 below.

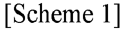

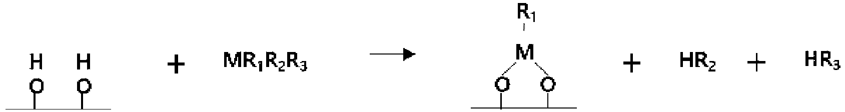

In Scheme 1, the step of dosing the metal precursor on the surfaces of the metal oxide layers 20_1 and 20_2 is shown as an example. As an example of the metal precursor, MR₁R₂R₃ is illustrated for the case where the oxidation number of M is 3, but the metal precursor may contain two R groups or four or more R groups depending on the oxidation number of M. M may be a metal selected from the group consisting of zinc (Zn), tin (Sn), indium (In), cadmium (Cd), aluminum (Al), titanium (Ti), manganese (Mn), iron (Fe), cobalt (Co), copper (Cu)), tungsten (W), and silicon (Si), and R₁, R₂, and R₃ may be an alkyl group, a halide group, an alkoxy group, or a hydroxyl group regardless of each other. However, the metal precursor is not limited thereto.

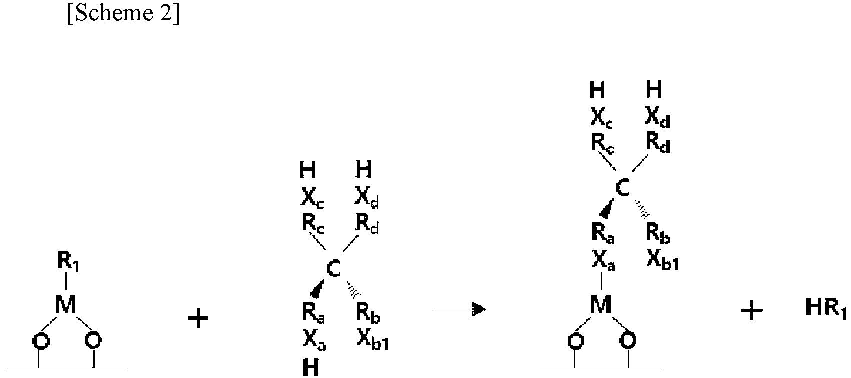

In Scheme 2, M and R₁ are as defined in Scheme 1, and Xₐ, X_{b1}, X_{c}, X_{d}, Rₐ, R_{b}, R_{c}, and R_{d} are as defined in Formula 3.

In Scheme 2, the reaction scheme using the organic precursor of Formula 3 is shown, but when the organic precursor of Formula 4 is used, it may be similar to Scheme 2 except that X_{b2} forms a bond with another M atom.

When the organic-inorganic hybrid layers 30_1 and 30_2 are formed by repeating a unit cycle including the metal atomic layer M2 forming step and the organic molecular layer OL forming step twice or more, or when the metal oxide layer 20_2 is formed on the organic-inorganic hybrid layer 30_1, the metal precursor dosing step may be represented by Scheme 3 below.

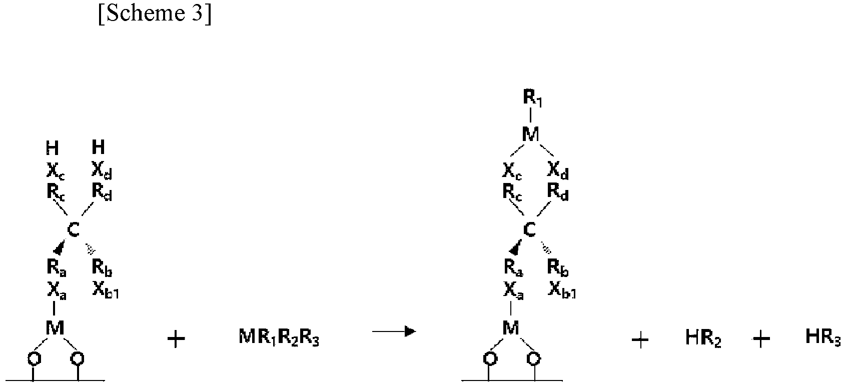

In Scheme 3, M, R₁, R₂, and R₃ are as defined in Scheme 1, and Xₐ, X_{b1}, X_{c}, X_{d}, Rₐ, R_{b}, R_{c}, and R_{d} are as defined in Formula 3. However, MR₁R₂R₃ may be an example of a metal precursor for forming the metal atomic layer M2 in the organic-inorganic hybrid layers 30_1 and 30_2 or a metal precursor for forming the metal atomic layer M1 in the metal oxide layer 20_2.

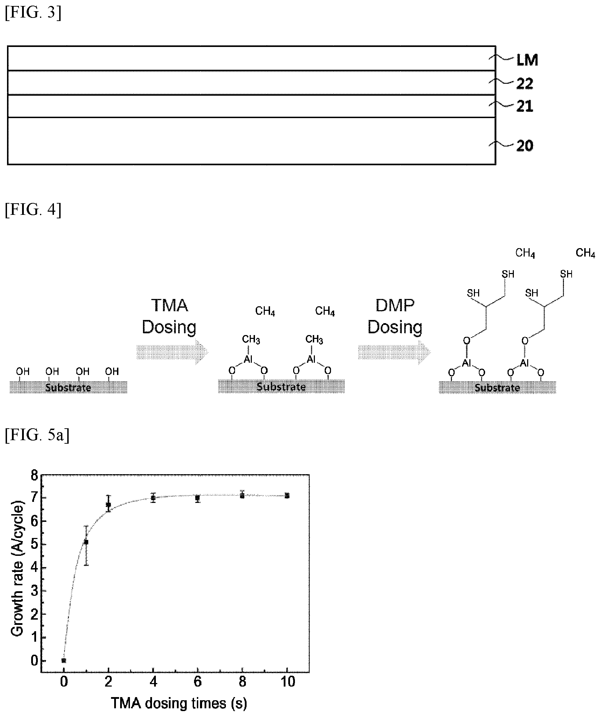

FIG. 3 is a cross-sectional view showing an organic electronic device having an organic-inorganic laminate according to an embodiment of the present invention.

Referring to FIG. 3, the organic electronic device may have a substrate 20, an organic device layer 22 on the substrate 20, and the organic-inorganic laminate LM described with reference to FIG. 1 on the organic device layer 22. A selection element layer 21 may be interposed between the substrate 20 and the organic device layer 22. The organic device layer 22 may be an organic light emitting diode layer as an example of an organic optical device layer. The selection element layer 21 may be a layer including selection elements capable of selecting and turning on some of organic devices provided in the organic device layer, and may be a thin film transistor layer.

The organic-inorganic laminate LM may serve as a gas barrier that blocks external moisture or oxygen from penetrating into the organic device layer 22. As a result, the reliability of the organic device layer vulnerable to moisture or oxygen may be improved. In particular, as described above, when the organic-inorganic laminate LM includes the organic molecular layer OL represented by Formula 1 or Formula 2, excellent gas barrier properties can be exhibited even when subjected to stress such as bending. For this reason, even when the organic electronic device is a flexible device, a long lifespan and high reliability may be exhibited.

Hereinafter, preferred experimental examples are presented to help the understanding of the present invention. However, the following experimental examples are only for helping understanding of the present invention, and the present invention is not limited by the following experimental examples.

### Organic-inorganic hybrid film Preparation Example 1

FIG. 4 is a schematic diagram illustrating a process according to organic-inorganic hybrid film Preparation Example 1.

Referring to FIG. 4, a Si(100) substrate was washed with distilled water and acetone, and then purged with N₂ gas 2-3 times to remove contaminants from the surface of the substrate. The Si substrate was provided with hydroxy groups (-OH) on the surface. A Si substrate from which contaminants had been removed was placed in a reaction chamber, and TMA (trimethyl aluminum, Al(CH₃)₃) in a gas phase as a metal precursor was dosed with argon as a carrier gas in the reaction chamber, and a film containing -(O)₂AlCH₃ and/or -OAl(CH₃)₂ was formed on the Si substrate by reacting the hydroxyl group and the TMA, and then unreacted precursors and the product gas, CH₄, were purged from the reaction chamber using argon. Accordingly, a first sub-cycle consisting of TMA dosing/purge was performed. After that, DMP (2,3-dimercapto-1-propanol, HOCH₂CH(SH)CH₂SH) in the gas phase as an organic precursor was dosed with argon as a carrier gas into the reaction chamber to react with the film containing -(O)₂AlCH₃ and/or -OAl(CH₃)₂, and then unreacted precursors and the product gas, CH₄, were purged from the reaction chamber using argon. Accordingly, a second sub-cycle consisting of DMP dosing/purge was performed. The first sub-cycle and the second sub-cycle constitute a unit cycle for forming a unit layer of the organic-inorganic hybrid film.

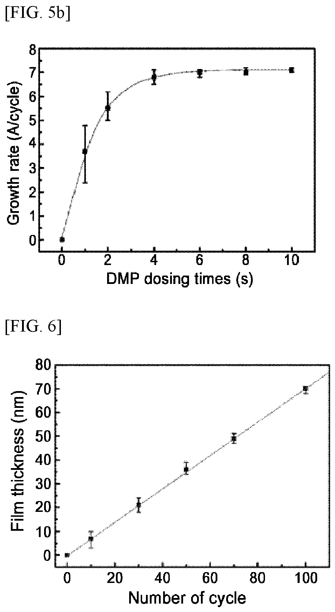

FIG. 5a is a graph showing the thickness of the organic-inorganic hybrid film per unit cycle according to changing the TMA dosing time in the TMA dosing step of the organic-inorganic hybrid film Preparation Example 1, and FIG. 5b is a graph showing the thickness of the organic-inorganic hybrid film per unit cycle according to changing the DMP dosing time in the DMP dosing step of the organic-inorganic hybrid film Preparation Example 1.

Referring to FIGs. 5a and 5b, in the case of TMA, when dosing for 2 seconds, the film thickness per unit cycle began to be saturated to about 7 Å, and in the case of DMP, when dosing for 4 seconds, the film thickness per unit cycle started to be saturated to about 7 Å. This saturation of the film thickness means that the site for surface reaction with the reactant was exhausted, and also a self-limiting reaction, in which only the reaction between the reactant and the surface occurs without the reaction between the reactants, was performed. In addition, from this, it can be seen that 2 seconds is appropriate for the dosing time of TMP and 4 seconds is appropriate for the dosing time of DMP.

FIG. 6 is a graph showing the thickness of the organic-inorganic hybrid film according to the number of unit cycles according to organic-inorganic hybrid film Preparation Example 1. In this case, unit cycles were performed in a state where the dosing time of TMP was fixed to 2 seconds and the dosing time of DMP was fixed to 5 seconds in organic-inorganic hybrid film Preparation Example 1.

Referring to FIG. 6, it can be seen that the organic-inorganic hybrid film is formed to a thickness of about 7 Å per unit cycle.

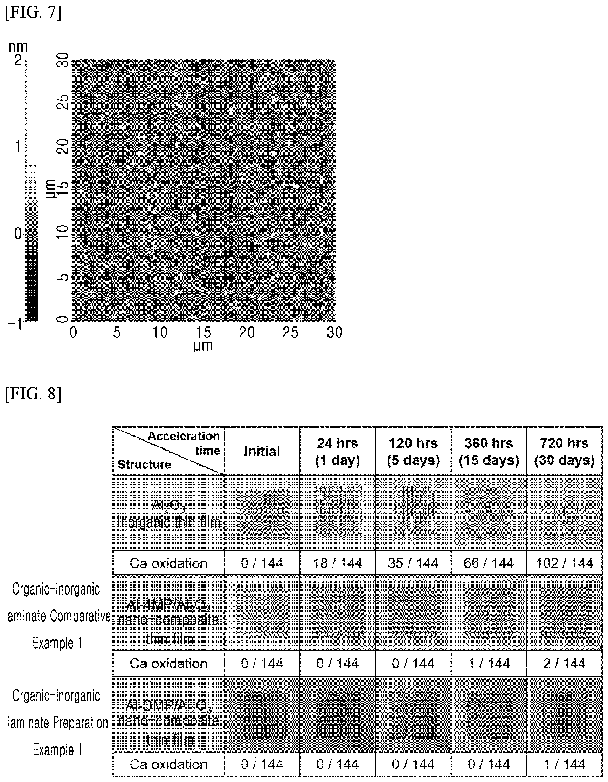

FIG. 7 is an image taken using an atomic force microscope (AFM) of the surface of the resultant after performing the unit cycle according to the organic-inorganic hybrid film Preparation Example 1 15 times. In this case, in the organic-inorganic hybrid film Preparation Example 1, unit cycles were performed while the dosing time of TMP was fixed to 2 seconds and the dosing time of DMP was fixed to 5 seconds.

Referring to FIG. 7, it can be seen that the root mean squared roughness (Rq) of the organic-inorganic hybrid film in which the unit cycle according to organic-inorganic hybrid film Preparation Example 1 was performed 15 times was about 0.257 nm, which was very good.

### Organic-inorganic laminate Preparation Example 1

The glass substrate was washed with distilled water and acetone, and then purged with N₂ gas 2-3 times to remove contaminants on the substrate surface. The glass substrate was provided with hydroxyl groups (-OH) on the surface. The glass substrate from which contaminants had been removed was placed in a reaction chamber, and TMA (trimethyl aluminum, Al(CH₃)₃) in a gas phase as a metal precursor was dosed with argon as a carrier gas in the reaction chamber, and a film containing -(O)₂AlCH₃ and/or -OAl(CH₃)₂ was formed on the glass substrate by reacting the hydroxyl group and the TMA (TMA dosing), and then unreacted precursors and the product gas, CH₄, were purged from the reaction chamber using argon (purge). After that, gaseous H₂O as an oxidizing agent was dosed with argon as a carrier gas in the reaction chamber, and reacted with a film containing-(O)₂AlCH₃ and/or -OAl(CH₃)₂ to form a film containing -(O)₂AlOH and/or-OAl(OH)₂ (H₂O dosing), and then the unreacted precursor and CH₄ as a product gas were purged from the reaction chamber using argon (purge). The unit cycle consisting of TMA dosing/purge/H₂O dosing/purge was repeated 8 times to form an Al₂O₃ film on the glass substrate.

In a reaction chamber in which an Al₂O₃ film containing -(O)₂AlOH and/or-OAl(OH)₂ as the uppermost unit layer is formed on a glass substrate, TMA in the gas phase was dosed with argon as a carrier gas, and the TMA was reacted with the hydroxyl group (-OH) of -(O)₂AlOH and/or -OAl(OH)₂ to form a film containing-OAl(CH₃)₂ and/or -(O)₂AlCH₃ (TMA dosing), and then argon was used to purge the unreacted precursor and the product gas, CH₄, from the reaction chamber (purge). After that, DMP in the gas phase as an organic precursor was dosed together with argon as a carrier gas into the reaction chamber to react with a film containing-OAl(CH₃)₂ and/or -(O)₂AlCH₃ (DMP dosing), and then argon was used to purge the unreacted precursor and the product gas, CH₄, from the reaction chamber (purge). A unit layer of the organic-inorganic hybrid film was formed through a unit cycle consisting of TMA dosing/purge/DMP dosing/purge.

After repeating the steps of forming the Al₂O₃ film and forming the unit layer of the organic-inorganic hybrid film 66 times, finally forming the Al₂O₃ film was performed to prepare an organic-inorganic laminate having a thickness of about 100 nm.

### Organic-inorganic laminate Preparation Example 2

Instead of using a glass substrate, the PET substrate was washed with distilled water and acetone, then purged 2-3 times with N₂ gas to remove contaminants on the substrate surface, and UV was irradiated on the PET substrate from which the contaminants were removed to generate hydroxyl groups on the surface of the PET substrate. An organic-inorganic laminate was prepared in the same manner as in organic-inorganic laminate Preparation Example 1, except that the PET substrate surface-treated to have hydroxyl groups was placed in the reaction chamber.

### Organic-inorganic laminate Comparative Example 1

An organic-inorganic laminate was prepared in the same manner as in organic-inorganic laminate Preparation Example 1, except that 4-MP (4-mercapto phenol) was used instead of DMP in the step of forming the unit layer of the organic-inorganic hybrid film.

### Organic-inorganic laminate Comparative Example 2

An organic-inorganic laminate was prepared in the same manner as in organic-inorganic laminate Preparation Example 2, except that 4-MP (4-mercapto phenol) was used instead of DMP in the step of forming the unit layer of the organic-inorganic hybrid film.

### Al₂O₃ inorganic thin film Comparative Example 1

The step of forming the organic-inorganic hybrid film in organic-inorganic laminate Preparation Example 1 was omitted, and the unit cycle consisting of the TMA dosing/purge/H₂O dosing/purge was repeated 1000 times to form an Al₂O₃ film of about 100 nm on the glass substrate.

### Al₂O₃ inorganic thin film Comparative Example 2

The step of forming the organic-inorganic hybrid film in organic-inorganic laminate Preparation Example 2 was omitted, and the unit cycle consisting of the TMA dosing/purge/H₂O dosing/purge was repeated 1000 times to form an Al₂O₃ film of about 100 nm on the PET substrate.

### Experimental Example: Air Stability Test 1

The glass substrate was washed with distilled water and acetone, and then purged with N₂ gas 2-3 times to remove contaminants on the substrate surface. 144 calcium dots were formed on the upper surface of each of the three glass substrates from which contaminants were removed. An organic-inorganic laminate of about 100 nm was formed on the calcium dots of one substrate by using the same method as in organic-inorganic laminate Preparation Example 1. An organic-inorganic laminate having a thickness of about 100 nm was formed on the calcium dots of another substrate by using the same method as in organic-inorganic laminate Comparative Example 1. An Al₂O₃ inorganic thin film of about 100 nm was formed on the calcium dots of the other substrate by using the same method as in Al₂O₃ inorganic thin film Comparative Example 1.

While these three samples were stored under constant temperature and humidity accelerated conditions of 85% RH (Relative Humidity) and 85 °C, the number of oxidized calcium dots was counted at the time points of 1 day, 5 days, 15 days, and 30 days.

FIG. 8 shows the results according to the air stability test 1.

Referring to FIG. 8, compared to the sample in which Al₂O₃ inorganic thin films are located above and below the calcium dots, the sample in which organic-inorganic laminates according to organic-inorganic laminate Preparation Example 1 are located above and below the calcium dots and the sample in which organic-inorganic laminates according to organic-inorganic laminate Comparative Example 1 are located above and below the calcium dots exhibits relatively low degree of oxidation of the calcium dots, and exhibits excellent gas permeation prevention properties. Further, it can be seen that the sample in which organic-inorganic laminates according to organic-inorganic laminate Preparation Example 1 are located above and below the calcium dots exhibits more excellent gas penetration prevention properties compared to the sample in which organic-inorganic laminates according to organic-inorganic laminate Comparative Example 1 are located above and below the calcium dots.

### Experimental Example: Air Stability Test 2

144 calcium dots were formed on the resultant according to organic-inorganic laminate Preparation Example 2, and the organic-inorganic laminate of about 100 nm was laminated on the calcium dots using the same method as in organic-inorganic laminate Preparation Example 2. 144 calcium dots were formed on the resultant according to organic-inorganic laminate Comparative Example 2, and the organic-inorganic laminate of about 100 nm was laminated on the calcium dots using the same method as in organic-inorganic laminate Comparative Example 2. 144 calcium dots were formed on the resultant according to Al₂O₃ inorganic thin film Comparative Example 2, and the Al₂O₃ inorganic thin film of about 100 nm was laminated on the calcium dots using the same method as in Al₂O₃ inorganic thin film Comparative Example 2.

After repeating 1000 times of bending these three samples so as to have a radius of 0.3 cm or 0.5 cm and unfolding, and stored under constant temperature and humidity acceleration conditions of 85% RH (Relative Humidity) and 85 °C, the number of oxidized calcium dots was counted at the time points when 1 day, 5 days, 15 days, and 30 days have elapsed.

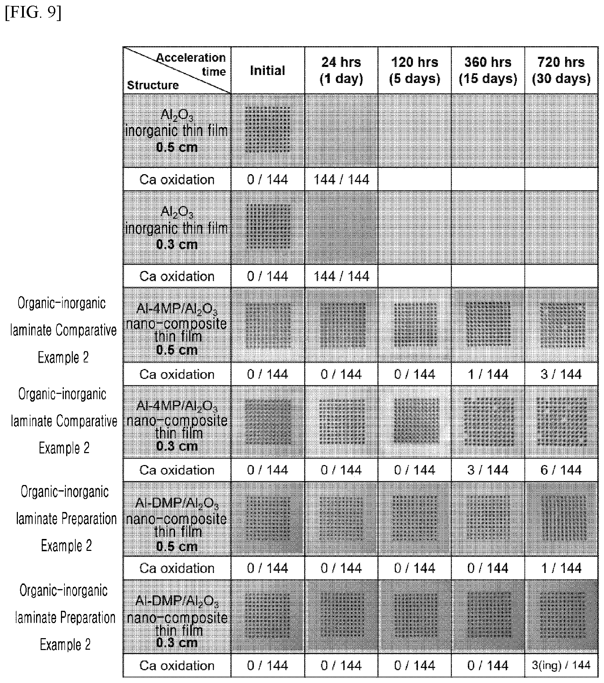

FIG. 9 shows the results according to the air stability test 2.

Referring to FIG. 9, in the sample in which the Al₂O₃ inorganic thin films are located on the upper and lower portions of the calcium dots, all the calcium dots are oxidized within one day, while in the sample in which the organic-inorganic laminates according to the organic-inorganic laminate Preparation Example 2 are located on the upper and lower portions of the calcium dots and the sample in which the organic-inorganic laminates according to the organic-inorganic laminate Comparative Example 2 are located on the upper and lower portions of the calcium dots, the number of oxidized calcium dots is small thereby exhibiting excellent gas permeation prevention properties. Further, it can be seen that the sample in which organic-inorganic laminates according to organic-inorganic laminate Preparation Example 2 are located above and below the calcium dots exhibits more excellent gas penetration prevention properties compared to the sample in which organic-inorganic laminates according to organic-inorganic laminate Comparative Example 2 are located above and below the calcium dots.

While the exemplary embodiments of the present invention have been described above, those of ordinary skill in the art should understood that various changes, substitutions and alterations may be made herein without departing from the spirit and scope of the present invention as defined by the following claims.

## Claims

1. An organic-inorganic laminate comprising:
at least two metal oxide layers; and
an organic-inorganic hybrid layer disposed between the metal oxide layers and including at least one unit layer including a metal atomic layer and an organic molecular layer represented by Formula 1 or 2 below:
[Formula 1] (-XₐRₐ) (X_{b1}R_{b}) C (R_{c}X_{c}-) (R_{d}X_{d}-)
[Formula 2] (-XₐRₐ) (-X_{b2}R_{b}) C (R_{c}X_{c}-) (R_{d}X_{d}-)
In Formula 1 or Formula 2, a plurality of - means a bond with a metal in the metal atomic layer or the metal oxide layer regardless of each other, and Xₐ, X_{b2}, X_{c}, and X_{d} are O, S, Se or NH regardless of each other, X_{b1} is hydrogen, and Rₐ, R_{b}, R_{c}, and R_{d} are, irrespective of each other, a bond or a C1 to C5 alkylene group.

2. The organic-inorganic laminate of claim 1, wherein the C1 to C5 alkylene group is a C1 to C3 alkylene group.

3. The organic-inorganic laminate of claim 1, wherein Xₐ is O, X_{b2} is O, X_{c} and X_{d} are S, and X_{b1} is hydrogen.

4. The organic-inorganic laminate of claim 1, wherein the organic molecular layer is (-OCH₂)HC(S-)(CH₂S-).

5. The organic-inorganic laminate of claim 1, wherein the metal oxide layer is a transition metal oxide, a post-transition metal oxide, or a metalloid oxide layer.

6. The organic-inorganic laminate of claim 5, wherein the metal oxide layer is an Al₂O₃ layer.

7. The organic-inorganic laminate of claim 1, wherein the metal oxide layer is a layer in which metal atomic layers and oxygen atomic layers are alternately stacked.

8. The organic-inorganic laminate of claim 1, wherein the metal atomic layer of the organic-inorganic hybrid layer is an Al layer.

9. An organic-inorganic laminate comprising:
alternately stacked first metal oxide layers and organic-inorganic hybrid layers;
a second metal oxide layer is disposed on the uppermost organic-inorganic hybrid layer among the alternately stacked first metal oxide layers and organic-inorganic hybrid layers,
wherein the organic-inorganic hybrid layer includes at least one unit layer including a metal atom layer and an organic molecular layer,
the organic molecular layer has an alkyl group having 2 to 21 carbon atoms as a body to form a tetrahedron centered on any one carbon atom of the alkyl group and four vertices, oxygen(s) bonded to the metal atom layer at one or two of the four vertices, and sulfurs bonded to the metal of the metal oxide layer at two of the four vertices.

10. The organic-inorganic laminate of claim 9, wherein the organic molecular layer is represented by Formula 1 or Formula 2 below:
[Formula 1] (-XₐRₐ) (X_{b1}R_{b}) C (R_{c}X_{c}-) (R_{d}X_{d}-)
[Formula 2] (-XₐRₐ) (-X_{b2}R_{b}) C (R_{c}X_{c}-) (R_{d}X_{d}-)
In Formula 1 or Formula 2, -Xₐ and - X_{b2} are oxygen bonded to the metal atomic layer, -X_{c} and -X_{d} are sulfur bonded to the metal of the metal oxide layer, X_{b1} is hydrogen, Rₐ, R_{b}, R_{c}, and R_{d} are a bond or a C1 to C3 alkylene group regardless of each other, but the total number of carbons constituting Rₐ, R_{b}, R_{c}, and R_{d} is 1 to 9.

11. The organic-inorganic laminate of claim 10, wherein the organic molecular layer is (-OCH₂)HC(S-)(CH₂S-).

12. The organic-inorganic laminate of claim 9, wherein the metal oxide layer is an Al₂O₃ layer in which Al atomic layers and oxygen atomic layers are alternately stacked.

13. The organic-inorganic laminate of claim 9, wherein the metal atomic layer of the organic-inorganic hybrid layer is an Al layer.

14. An organic-inorganic hybrid layer comprising:
at least one unit layer including a metal atomic layer and an organic molecular layer represented by Formula 1 or 2 below:
[Formula 1] (-XₐRₐ) (X_{b1}R_{b}) C (R_{c}X_{c}-) (R_{d}X_{d}-)
[Formula 2] (-XₐRₐ) (-X_{b2}R_{b}) C (R_{c}X_{c}-) (R_{d}X_{d}-)
In Formula 1 or Formula 2, a plurality of - means a bond, and Xₐ, X_{b2}, X_{c}, and X_{d} are O, S, Se or NH regardless of each other, X_{b1} is hydrogen, and Rₐ, R_{b}, R_{c}, and R_{d} are, irrespective of each other, a bond or a C1 to C5 alkylene group.

15. The organic-inorganic hybrid layer of claim 14, wherein, in Formula 1 or Formula 2, Xa and X_{b2} are oxygen, X_{c} and X_{d} are sulfur, X_{b1} is hydrogen, and Rₐ, R_{b}, R_{c}, and R_{d} are a bond or a C1 to C3 alkylene group regardless of each other, but the total number of carbons constituting Rₐ, R_{b}, R_{c}, and R_{d} is 1 to 9.

16. The organic-inorganic hybrid layer of claim 14, wherein the organic molecular layer is (-OCH₂)HC(S-)(CH₂S-).

17. The organic-inorganic hybrid layer of claim 14, wherein the metal atomic layer is an Al layer.

18. An organic electronic device comprising an organic-inorganic laminate of Claim 1 or Claim 9 as a gas barrier layer.
